# EUROPEAN PATENT SPECIFICATION

(11) **EP 1 422 055 B1**
(45) Date of publication and mention of the grant of the patent: **23.01.2013**
(21) Application number: 02751721.8
(22) Date of filing: 26.07.2002
(51) Int. Cl.: B32B 15/08, H01G 4/18, H05K 1/16

(54) **CAPACITOR LAYER FORMING BOTH-SIDE COPPER-CLAD LAMINATED SHEET AND PRODUCTION METHOD THEREFOR**
KONDENSATORSCHICHT BILDENDE, BEIDSEITIG MIT KUPFER BESCHICHTETE LAMINIERTE FOLIE UND HERSTELLUNGSVERFAHREN DAFÜR
COUCHE DE CONDENSATEUR FORMANT UNE FEUILLE LAMINEE GAINEE DE CUIVRE SUR DEUX COTES ET SON PROCEDE DE PRODUCTION

(30) Priority: 30.07.2001 JP 2001228850
(43) Date of publication of application: 26.05.2004
(73) Proprietor: MITSUI MINING & SMELTING CO., LTD., Tokyo 141-8584 (JP)
(72) Inventor: KUWAKO, Fujio, Ageo-shi, Saitama 362-0013 (JP); YAMAZAKI, Kazuhiro, Ageo-shi, Saitama 362-0013 (JP); MATSUSHIMA,Toshifumi, Ageo-shi, Saitama 362-0021 (JP)
(74) Representative: Setna, Rohan P.
(86) International application number: PCT/JP2002/007600
(87) International publication number: WO 2003/011589

(56) References cited:
- EP-A1- 0 902 048
- EP-A2- 0 008 107
- JP-A- 1 030 291
- JP-A- 2 168 694
- JP-A- 7 154 042
- JP-A- 8 120 098
- JP-A- 8 197 681
- JP-A- 11 340 078
- JP-A- 2000 043 211
- US-A- 5 102 722
- US-A- 5 103 293
- US-B1- 6 215 649

## Description

### Technical Field

The present invention relates to a double-sided copper clad laminate for forming a capacitor layer in an internal layer of a multilayer printed wiring board and a method for manufacturing the same.

### Background Art

Recently, an operation speed of a computer has been enhanced rapidly and dramatically. Even personal computers intended for home use have clock frequencies in GHz, and a signal transfer rate will be inevitably increased. Besides, as office automation and office LAN systems have been common, and information networks across the world have been provided, information management over a plurality of computers has become required, and thus, a server has become widely used as a computer peripheral device.

Generally, the server has a bulk memory for enabling concentrated management of a large quantity of information, and is required to have a high operation performance enough to accommodate simultaneous accesses from a plurality of computers. Therefore, the server is required to have a higher signal transfer rate and to be less susceptible to malfunction.

To realize the environment as described above, besides a circuit design of a central processing unit (CPU), performance of an IC chip and the like, a circuit design of a printed wiring board for implementing them is very important. To address the enhancement in the signal transfer rate, manufacturers of the printed wiring board have devised various measures. For example, in terms of structure, the multilayer printed wiring board has been developed, or in terms of circuit configuration, the circuit design has been modified to shorten a signal transfer length.

In particular, a capacitor serves to supply operating power for a device with stability, and is typically arranged on an external layer of the printed wiring board. However, since the capacitor can be thinned and the thinned capacitor can exhibit good properties, a method of using a double-sided copper clad laminate to provide a capacitor in an internal layer of a multilayer printed wiring board has become common. A capacitor layer is formed using the thin double-sided copper clad laminate.

In a typical method for manufacturing the double-sided copper clad laminate used for forming the capacitor layer, an FR-4 base material, which is a glass cloth impregnated with epoxy resin, is used as an insulating material, and copper foils are applied to both sides of the base material. In order to ensure a high electric capacity, the thinnest possible FR-4 base material has been used. The double-sided copper clad laminate thus conFig.d, on both sides of which a capacitor circuit pattern is formed by etching, has been used as a member for forming an embedded capacitor layer of the multilayer copper clad laminate.

The member for forming an embedded capacitor layer, which is the double-sided copper clad laminate including the FR-4 base material, has the glass cloth serving as an aggregate in the insulating layer. Therefore, in thickness control of the member, there is a certain lower limit. In addition, when the laminated copper foils and FR-4 base material are hot-pressed to provide the copper clad laminate, a waviness shape of the glass cloth may appear on the surface of the laminate, so that it is difficult to provide a completely flat surface. For example, when a prepreg including a glass cloth as a frame member is used to form the insulating layer, a limit thickness of the prepreg is 50 µm.

There has been a need for a material capable of further enhancing the capacity, and there has been attempted a method of manufacturing a thin double-sided copper clad laminate for forming a capacitor layer, in which two copper foils with a resin, each having a resin layer on one surface thereof, are stacked with the resin layers thereof facing each other. With this method, the resin layer can be readily thinned because it has no frame member. As a result, the insulating layer constituting the dielectric layer can be thinned, and a higher capacity can be attained.

However, as the copper foils constituting the thin double-sided copper clad laminate for forming the capacitor layer, an electrodeposited copper foil is generally used. And, the interface of the electrodeposited copper foil with the resin layer is subject to a nodular treatment to have irregularities, which are intended to provide an anchoring effect for enhancing the adhessiveness between the electrodeposited copper foil and the resin layer.

Therefore, as the insulating layer of the double-sided copper clad laminate becomes thinner, the nodular-treated surfaces of the copper foils become close to each other. Then, if the nodular-treated surfaces have an abnormally developed part, a short-circuit occurs partially between the copper foils, and when a voltage is applied between the copper foils, a current flows from one copper foil to another, which is a significant problem in thinning the insulating layer.

The copper clad laminate used as the member for forming the embedded capacitor layer can be readily bent because of its thin insulating layer, so that a fracture readily occurs in the insulating layer. Thus, handling of such a copper clad laminate has been difficult. In particular, when the copper clad laminate contains a filler, there is a problem in that the insulating layer becomes brittle. If the insulating layer is thin and lacks strength, there is a problem in forming the capacitor circuit through etching. When a shower of etchant of a certain pressure is applied to the surface of the double-sided copper clad laminate to be etched, the insulating layer, which is thin and does not have enough toughness, is fractured by the showering pressure, and an expected insulating layer cannot be obtained. There has been a need for a method for solving the problems described above. US-A-6219649 discloses a double-sided copper clad laminate according to the preamble of claim 1.

### Brief Description of the Drawings

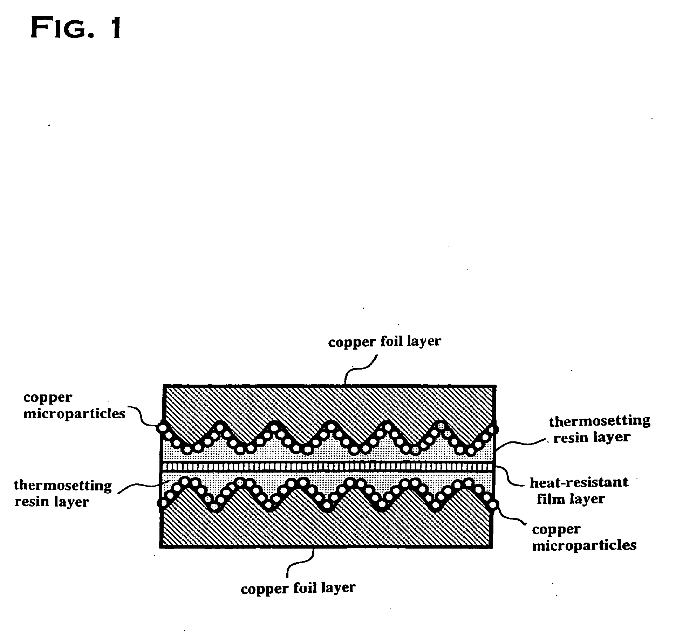

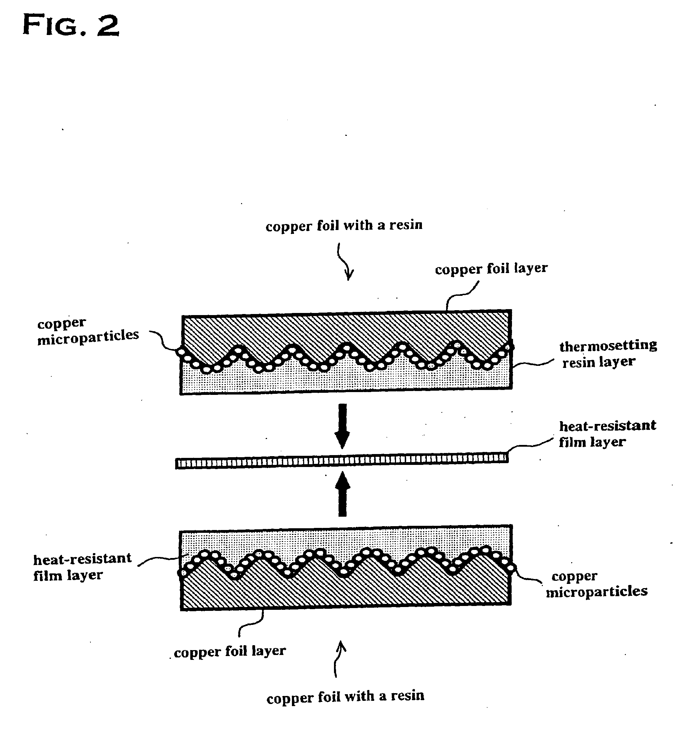

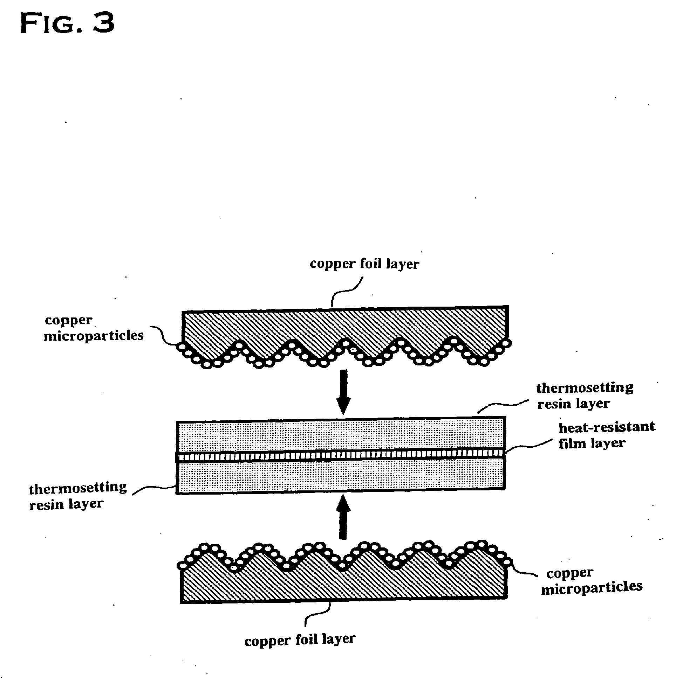

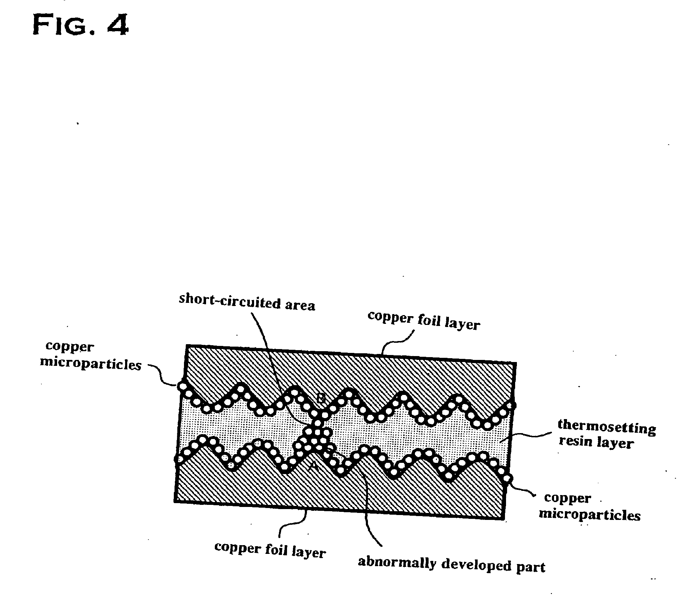

Fig. 1 is a schematic cross-sectional view of a double-sided copper clad laminate for forming a capacitor layer. Figs. 2 and 3 are conceptual diagram illustrating a method for manufacturing the double-sided copper clad laminate for forming a capacitor layer. Fig. 4 is a schematic cross-sectional view of a double-sided copper clad laminate for forming a capacitor layer.

### Disclosure of the Invention

The invention is disclosed in claims 1,4. Various embodiments are disclosed in the dependent claims.

Thus, the inventors have attained the invention described below after earnest studies for solving the problems described above.

According to claim 1, a double-sided copper clad laminate for forming a capacitor layer has a layered structure comprising conductive copper foil layers arranged at outer layers thereof and a resin layer, which is dielectric, sandwiched between the copper foils, and is characterized in that the resin layer has a three-layer structure comprising a thermosetting resin layer, a heat resistant film layer and a thermosetting resin layer in this order and has a total thickness of 25 µm or less, the thermosetting resin layer is made of epoxy resin material, and the heat resistant film layer is made of a resin material that has ordinary properties of a Young's modulus of 300kg/mm² or more, a tensile strength of 20 kg/mm² or more and an elongation percentage of 5% or more, a softening point higher than a molding temperature for the thermosetting resin forming the thermosetting resin layers on both sides thereof, and a relative dielectric constant of 2.5 or more.

In a conventional double-sided copper clad laminate for forming a capacitor layer manufactured using two copper foils with a resin, as shown in Fig. 4, the resin layers, which constitute a dielectric between the copper foils, are united into one by hot-pressing. Thus, if the resin layer is thinned, when a voltage is applied between the copper foils, a tip of copper microparticles abnormally developed in a nodular treatment at point A in this drawing comes into contact with a surface (point B) of the opposed copper foil, thereby causing short-circuit.

On the other hand, as shown in the schematic cross-sectional view in Fig. 1, the double-sided copper clad laminate for forming a capacitor layer as set forth in claim 1 has the three-layer structure comprising the thermosetting resin layer, the heat resistant film layer and the thermosetting resin layer in this order. The shown three-layer structure demonstrates that the three-layer structure can be clearly recognized after the double-sided copper clad laminate is provided by hot pressing. Thus, all of the three layers must not be softened to form a mixed layer during the hot pressing in the manufacture thereof. The heat resistant film layer must be made of a resin material having a softening point higher than a molding temperature for the thermosetting resin forming the thermosetting resin layers on both sides of the heat resistant film layer. Here, in this specification, the softening point is measured according to Vicat softening point test method defined in JIS K 7206.

The resin layer having the three-layer structure comprising the thermosetting resin layer, the heat resistant film layer and the thermosetting resin layer in this order must have a total thickness of 25 µm or less. The resin layer constitutes the dielectric layer in the capacitor. An electric capacity of a capacitor is inversely proportional to the thickness of the dielectric layer. Accordingly, as the dielectric layer becomes thinner, the electric capacity and the quantity of stored electricity become larger. The stored electricity contributes part of power supply, leading to power saving. Since the thickness of the resin layer is determined in stages of product design or circuit design, it is determined to be 25 µm or less in consideration of market requirements.

In addition, the heat resistant film layer needs to have ordinary properties of a Young's modulus of 300kg/mm² or more, a tensile strength of 20 kg/mm² or more and an elongation percentage of 5% or more. Such mechanical properties are defined in order to prevent tearing of the resin layer from being caused by showering of an etchant during etching to form a capacitor circuit pattern as described above. That is, when the heat resistant film layer, which is an intermediate layer of the three-layer structure of the thermosetting resin layer, the heat resistant film layer and the thermosetting resin layer, is made of a resin having the above-described mechanical properties, tearing of the resin layer due to showering during etching can be prevented. Here, the properties of the heat resistant film are defined in an ordinary state. This is because the properties does not vary even if the heat resistant film is heated to a temperature equal to or less than the softening point thereof.

Typically, a showering pressure of the etchant, which is measured at a strainer, falls within a range from 10 to 15 kg/cm², and when the etchant is ejected from a nozzle, a significantly high pressure shower is provided. If the resin layer is made of a hard and brittle material and is extremely thin, it is fractured by the pressure of the shower. Thus, by changing the material of the intermediate heat resistant film layer to a material having both strength and certain toughness, fracture of the resin layer can be prevented even if the epoxy resin layer constituting the thermosetting resin layer is hard and brittle.

Here, "the thermosetting resin layer is made of epoxy resin material". This is because, in consideration of the history of the development of the copper foil, compatibility of the epoxy resin with the nodular treatment performed on the copper foil surface is excellent. Therefore, the epoxy resin used is not particularly restricted in its composition, and presupposing that adhesion stability at the interface between the copper foil and the epoxy resin is ensured, the composition of the epoxy resin may be appropriately adjusted in consideration of the compatibility with the resin constituting the heat resistant film layer. The "epoxy resin material" herein is not limited to a material containing an epoxy resin as a principal component, and refers to a material having an epoxy group associated with curing and having a superior adhessiveness with the copper foil.

For the heat resistant film layer and the thermosetting resin layer, a resin having a high relative dielectric constant is used to attain a high capacitance. The relative dielectric constant referred to herein indicates a value measured with the impedance material analyzer HP4291A under the condition of 1 MHz according to the paragraph 2.5.5.9 of the IPC-TM-650, which is a test manual of the IPC standard.

With such a layered structure, there exists the heat resistant film layer having a high softening point. Therefore, even if a part of the nodular surfaces of the copper foils located at both sides of the double-sided copper clad laminate for forming a capacitor layer is abnormally developed in the nodular treatment, short-circuit does not occur between the copper foils, and discharge does not occur when a voltage is applied between the copper foils.

Thus, a kind of the resin material constituting the heat resistant film is quite important. As set forth in claim 2, the heat resistant film layer is made of any of polyethylene terephthalate, polyethylene naphtahalate, polyvinylcarbazole, polyphenylene sulfide, polyamide, aromatic polyamide, polyamide imide, polyethernitrile and polyetheretherketone resin. These materials have generally a softening point higher than that of the epoxy resin, is superior in insulation performance, which is essential as basic properties of dielectric, and have a relative dielectric constant of 2.5 or higher. More strictly speaking, the molding temperature of the epoxy resin can be set arbitrarily by changing the denaturation condition thereof. Thus, depending on the material of the heat resistant film described above, the epoxy resin may be changed so as to have a molding temperature lower than the softening point of the heat resistant film material.

In addition, as set forth in a claim, the thermosetting resin layer and the heat resistant film layer may contain ferroelectric microparticles as a filler. Here, the choice of which of the thermosetting resin layer and the heat resistant film layer to contain the filler can be determined arbitrarily according to the quality of design of the capacitor. For example, only the thermosetting resin layer may contain the filler, only the heat resistant film layer may contain the filler, or both the thermosetting resin layer and the heat resistant film layer may contain the filler. The filler contained can provide a higher relative dielectric constant of the heat resistant film layer, thereby increasing the electric capacity of the capacitor.

The ferroelectric microparticles herein have a relative dielectric constant higher than that of the resin material constituting the thermosetting resin layer or heat resistant film layer. For example, it may be barium titanate ceramic, lead titanate ceramic, calcium titanate ceramic, magnesium titanate ceramic, bismuth titanate ceramic, strontium titanate ceramic or lead zirconate ceramic. Since the ferroelectric microparticles have a relative dielectric constant ten or more times that of the material constituting the thermosetting resin layer or heat resistant film layer, containing them in the layers allows the electric capacity of the capacitor to be substantially improved.

And as set forth in a claim, it is preferred that a thickness of the heat resistant film layer surely falls within a range 0.5 to 12.5 µm. That is, the thickness of at least 0.5 µm is required in consideration of the required load voltage, the electric capacity and the resin material used to form the heat resistant film layer, and in order to ensure the complete interlayer insulation even when the outer copper foils have irregularities due to the nodular treatment and to prevent tearing of the resin layer caused by etchant showering. On the other hand, the electric capacity of the capacitor is inversely proportional to the distance between the outer copper foils. Thus, as the distance becomes smaller, a larger electric capacity can be attained, so that, naturally, the dielectric layer is desired to be as thin as possible. Consequently, considering the thickness of the epoxy resin layers, which are located on both sides of the heat resistant film layer, required to uniformly cover the copper foil surface with irregularities due to the nodular treatment, and the thickness of 25 µm or less required in the market, the upper limit of the thickness of the heat resistant film layer is 12.5 µm.

Now, an optimum method for manufacturing the double-sided copper clad laminate for forming a capacitor layer described above will be described. According to a claim, a method for manufacturing the double-sided copper clad laminate for forming a capacitor layer according to this invention, in which copper foils with a resin each having a thermosetting resin layer in a semi-cured state are overlaid on both surfaces of a heat resistant film layer with the resin layers thereof facing each other and hot-pressed for bonding, thereby producing the double-sided copper clad laminate, is characterized in that a material used for the heat resistant film layer is a resin material having ordinary properties of a Young's modulus of 300kg/mm² or more, a tensile strength of 20 kg/mm² or more and an elongation percentage of 5% or more, a softening point higher than a molding temperature for the thermosetting resin forming the thermosetting resin layers on both sides thereof, and a relative dielectric constant of 2.5 or more. That is, this is the method for manufacturing the double-sided copper clad laminate for forming a laminated capacitor layer in a manner shown in Fig. 2.

Here, for the heat resistant film layer, a resin material is used which has ordinary properties of a Young's modulus of 300kg/mm² or more, a tensile strength of 20 kg/mm² or more and an elongation percentage of 5% or more, a softening point higher than a molding temperature for the thermosetting resin forming the thermosetting resin layers on both sides thereof, and a relative dielectric constant of 2.5 or more. And, the resin material is required to have a softening point higher than a molding temperature for the thermosetting resin forming the thermosetting resin layers on both sides thereof, and a relative dielectric constant of 2.5 or more. In this way, since the heat resistant film layer has a high softening point, it is not softened at the molding temperature of the thermosetting resin layer constituted by epoxy resin. Thus, the definite three-layer structure can be maintained even after hot pressing. Accordingly, a heating condition of the hot-pressing is that a temperature is used that enables the epoxy resin to be cured and is equal to or lower than the molding temperature of the heat resistant film.

An, according to a claim, a method for manufacturing the double-sided copper clad laminate for forming a capacitor layer according to this invention, in which copper foils with a resin each having a thermosetting resin layer in a semi-cured state are overlaid on both surfaces of a heat resistant film layer with the resin layers thereof facing each other and hot-pressed for bonding, thereby producing the double-sided copper clad laminate, is characterized in that a material used for the heat resistant film layer is a resin material having ordinary properties of a Young's modulus of 300kg/mm² or more, a tensile strength of 20 kg/mm² or more and an elongation percentage of 5% or more, a softening point higher than a molding temperature for the thermosetting resin forming the thermosetting resin layers on both sides thereof, and a relative dielectric constant of 2.5 or more, and surfaces of the heat resistant film is subject to an adhessiveness improvement treatment before the heat resistant film is bonded with the copper foils with a resin. The manufacturing method is essentially the same as that described above, so that description of overlapping part is omitted. The difference is that the surfaces of the heat resistant film is subject to the adhessiveness improvement treatment.

The "adhessiveness improvement treatment" is a kind of surface nodular treatment that is previously performed chemically or physically on both surfaces of the heat resistant film to enhance the adhessiveness between the film and the thermosetting resin layer and to avoid delamination. Specifically, the surfaces of the heat resistant film is made nodular by a physical process, such as plasma treatment, corona discharge treatment and sandblasting, or a chemical process, such as acid treatment and alkali treatment. By making the surfaces of the heat resistant film nodular, an area of a contact surface of the film and the thermosetting resin layer is increased, thereby enhancing the adhesion stability.

According to another claim, a method for manufacturing the double-sided copper clad laminate for forming a capacitor layer according to this invention is characterized in that a resin layer constituting member is produced, the resin layer constituting member having a heat resistant film and thermosetting resin layers in a semi-cured state arranged on both sides of the heat resistant film, and copper foils are overlaid on both surfaces of the produced resin layer constituting member with contact surfaces thereof facing each other and hot-pressed for bonding. Furthermore, according to further claim, a method for manufacturing the double-sided copper clad laminate for forming a capacitor layer according to this invention is characterized in that a resin layer constituting member is produced, the resin layer constituting member having a heat resistant film subject to an adhessiveness improvement treatment and thermosetting resin layers in a semi-cured state arranged on both sides of the heat resistant film, and copper foils are overlaid on both surfaces of the produced resin layer constituting member with contact surfaces thereof facing each other and hot-pressed for bonding.

Fig. 3 schematically illustrates the methods for manufacturing the double-sided copper clad laminate for forming a capacitor layer as set forth in these claims. A commonality between these methods is that the resin layer constituting member having a heat resistant film and thermosetting resin layers on both sides of the heat resistant film, and copper foils are pasted to both surfaces of the produced resin layer constituting member. The resin layer constituting member used herein is provided by applying epoxy resin on both surfaces of the heat resistant film and drying the epoxy resin to a semi-cured state. Furthermore, it is clearly stated here that the copper foil referred to herein is not limited to a form of a copper foil as far as it can finally provide the double-sided copper clad laminate, and may be an electrodeposited copper foil, which is a normal one, a rolled copper foil, a copper foil with a carrier foil or the like. Therefore, the copper foil includes a copper foil having a nickel layer for forming a resistor circuit.

For the manufacturing method described above, either of the so-called badge method or continuous laminate method may be used. However, the continuous laminate method is desirable in terms of productivity. In the continuous laminate method, for example, two rolls of a copper foil with a resin having a thermosetting resin layer in the semi-cured state and a heat resistant film roll are used, the copper foils with a resin and the heat resistant film layer fed from the respective rolls are laminated, and the laminated copper foils with a resin and heat resistant film is passed through a hot-pressing roller for pre-bonding, finally cured in a curing zone, and then cut into a predetermined length.

### Best Mode for Carrying out the Invention

Now, the present invention will be described with reference to examples. In these examples, there are shown results obtained when a double-sided copper clad laminate for forming a capacitor layer was produced and etched to produce a printed wiring board used for forming a capacitor layer.

### First Example

In this example, a copper foil with a resin was produced, and thereby a double-sided copper clad laminate was produced as shown in Fig. 2. Thus, production of the copper foil with a resin will be described first. A thermosetting resin forming a resin layer of the copper foil with a resin was prepared as described below.

30 parts by weight of bisphenol A type phenoxy resin (YP-50, manufactured by TOTO KASEI Co., Ltd.), 30 parts by weight of bisphenol A type epoxy resin (EPICOAT828, manufactured by Japan Epoxy Resins Co., Ltd.), 40 parts by weight of cresol novolac type epoxy resin (YDCN704, manufactured by TOTO KASEI Co., Ltd.), 2.5 parts by weight of dicyandiamide as a hardener and 0.1 parts by weight of 2-ethyl-4-methylimidazol are dissolved in a solvent (DMF) to provide a thermosetting resin.

The thermosetting resin prepared as described above was spread on a low profile copper foil having a thickness of 35 µm (MLS, manufactured by Mitsui Mining & Smelting Co., Ltd) and dried at 130°C for 3 minutes, thereby providing a copper foil with a thermosetting resin layer, the dry thickness of the thermosetting resin layer being 5 µm in a state of so-called B stage (semi-cured state).

As for an insulating film, an aromatic polyamide film (trade name Aramica, manufactured by Asahi Kasei Corporation) having a thickness of 4 µm and a relative dielectric constant of 4.0 was used, and both surfaces thereof were made nodular by a corona discharge treatment for improving adhessiveness.

One copper foil with a resin was placed with the resin layer thereof facing upward, the heat resistant film was overlaid on the resin layer, and another copper foil with a resin was overlaid on the heat resistant film with the resin layer thereof facing downward. Then, forming was conducted by a normal vacuum heat pressing at 165°C for 60 minutes to provide a double-sided copper clad laminate for forming a 30 cm-square capacitor layer.

Sampling 10 double-sided copper clad laminates manufactured as described above, withstand voltage test was conducted on them with a voltage of DC 500 V for 30 seconds according to the paragraph 2.5.7 of the IPC-TM-650 standard. As a result, for all of them, short-circuit did not occur and the test was conducted successfully. Then, an average capacitance thereof was 0.31 nF/cm², and an average of thicknesses of the resin layers, which were measured by observation of the sections, was 10.5 µm

. Furthermore, dry films as etching resists were pasted to both surfaces of the double-sided copper clad laminate, a capacitor circuit pattern was exposed and developed to provide an etching circuit, and etching was conducted with an etching device. Then, tearing did not occur in any resin layer.

### Second Example

In this example, a resin layer constituting member was produced, and thereby a double-sided copper clad laminate was produced as shown in Fig. 3. Thus, production of the resin layer constituting member will be described first. A thermosetting resin forming a thermosetting resin layer on each surface of the resin layer constituting member was prepared as described below.

30 parts by weight of bisphenol A type phenoxy resin (YP-50, manufactured by TOTO KASEI Co., Ltd.), 30 parts by weight of bisphenol A type epoxy resin (EPICOAT828, manufactured by Japan Epoxy Resins Co., Ltd.), 40 parts by weight of cresol novolac type epoxy resin (YDCN704, manufactured by TOTO KASEI Co., Ltd.), 2.5 parts by weight of dicyandiamide as a hardener and 0.1 parts by weight of 2-ethyl-4-methylimidazol are dissolved in a solvent (DMF) to provide a thermosetting resin.

The thermosetting resin obtained as described above was spread on both surfaces of a dielectric film subject to the same adhessiveness improvement treatment as in the first example, and dried at 130°C for 3 minutes, thereby providing a resin layer constituting member with thermosetting resin layers, the dry thickness of the thermosetting resin layer being 5 µm in a state of so-called B stage (semi-cured state).

One copper foil having a thickness of 35 µm was placed with a contact surface thereof facing upward, the resin layer constituting member was overlaid on the contact surface, and another copper foil having a thickness of 35 µm was overlaid on the resin layer constituting member with the contact surface thereof facing downward. Then, forming was conducted by a normal vacuum heat pressing at 165°C for 60 minutes to provide a double-sided copper clad laminate for forming a 30 cm-square capacitor layer.

Sampling 10 double-sided copper clad laminates manufactured as described above, withstand voltage test was conducted on them with a voltage of DC 500 V for 30 seconds according to the paragraph 2.5.7 of the IPC-TM-650 standard. As a result, for all of them, short-circuit did not occur and the test was conducted successfully. Then, an average capacitance thereof was 0.30 nF/cm², and an average of thicknesses of the resin layers, which were measured by observation of the sections, was 11.0 µm.

Furthermore, dry films as etching resists were pasted to both surfaces of the double-sided copper clad laminate, a capacitor circuit pattern was exposed and developed to provide an etching circuit, and etching was conducted with an etching device. Then, tearing did not occur in any resin layer.

### Comparison Example

In this comparison example, a copper foil with a resin was produced, and as shown in Fig. 3, two copper foils with a resin were overlaid one on the other with the resin layers thereof facing each other and hot-pressed to produce a double-sided copper clad laminate. Basic methods of producing the copper foil with a resin and the thermosetting resin layer forming the resin layer of the copper foil with a resin used were the same as in the first example. Therefore, descriptions thereof will be omitted to avoid overlaps. The difference was the thickness of the resin layer of the dried copper foil with a resin. That is, the thermosetting resin layer having a dry thickness of 7 µm was formed on a contact surface of the copper foil (MLS, manufactured by Mitsui Mining & Smelting Co., Ltd) having a thickness of 35 µm.

Sampling 10 double-sided copper clad laminates manufactured as described above, withstand voltage test was conducted on them with a voltage of DC 500 V for 30 seconds according to the paragraph 2.5.7 of the IPC-TM-650 standard. As a result, in 9 of 10 laminates, short-circuit occurred immediately after energization. An average capacitance thereof was 0.32 nF/cm², and an average of thicknesses of the resin layers, which were measured by observation of the sections, was 9.5 µm. Observation of the site where short-circuit occurred revealed that copper microparticles were abnormally developed after the nodular treatment of the copper foil and brought close to the other copper foil.

Furthermore, dry films as etching resists were pasted to both surfaces of the double-sided copper clad laminate, a capacitor circuit pattern was exposed and developed to provide an etching circuit, and etching was conducted with an etching device. Then, tearing occurred in the resin layers of all the laminates.

### Industrial Applicability

A double-sided copper clad laminate for forming a capacitor layer according to this invention has a heat resistant film layer between copper foils. Thus, irregularities in a surface of one of the copper foils, which is nodular-treated, can be prevented from unnecessarily coming close to a surface of the other copper foil, whereby discharge can be prevented from occurring between the opposed copper foils, which are nodular-treated, when a high voltage equal to or higher than 500 V is applied between the copper foils. In addition, this invention has solved the significant problem in that a thin insulating layer would be fractured by a showering pressure, and an expected insulating layer could not be obtained. Consequently, the quality of the double-sided copper clad laminate for forming a capacitor layer can be constant, and manufacturing yield of the multilayer printed wiring board can be substantially improved.

## Claims

1. A double-sided copper clad laminate for forming a capacitor layer in an internal layer of a multilayer printed wiring board having a layered structure comprising conductive copper foil layers arranged at outer layers on both sides thereof and a dielectric resin layer sandwiched between the copper foils on the one side and the other side, wherein:
the resin layer has a three-layer structure comprising a thermosetting resin layer, a heat resistant film layer and a thermosetting resin layer in this order;
the thermosetting resin layer is made of epoxy resin material; and
the heat resistant film layer is made of a resin material that has a Young's modulus of 300 kg/mm² or more, a tensile strength of 20 kg/mm² or more and an elongation percentage of 5% or more, a softening point higher than a molding temperature for the thermosetting resin forming the thermosetting resin layers on both sides thereof, and a relative dielectric constant of 2.5 or more,
**characterised in that** the three-layer structure has a total thickness of 25 µm or less and the heat resistant film layer is made of any of polyethylene terephthalate, polyethylene naphthalate, polyvinylcarbazole, polyphenylene sulfide, polyamide, aromatic polyamide, polyamide imide,
polyethernitrile and polyetheretherketone resin.

2. The double-sided copper clad laminate according to Claim 1, wherein the thermosetting resin layer and/or the heat resistant film layer constituting the resin layer contains ferroelectric microparticles as a filler.

3. The double-sided copper clad laminate according to claim 1 or claim 2, wherein a thickness of the heat resistant film layer falls within a range 0.5 to 12.5 µm.

4. A method for manufacturing a double-sided copper clad laminate for forming a capacitor layer in an internal layer of a multilayer printed wiring board having a layered structure, said copper clad laminate being defined as in any one of Claims 1 to 3, in which copper foils with a resin each having a thermosetting resin layer in a semi-cured state are overlaid on both surfaces of a heat resistant film layer with the resin layers thereof facing each other and hot-pressed for bonding, thereby producing the double-sided copper clad laminate,
wherein a material used for the heat resistant film layer is a resin material having a Young's modulus of 300 kg/mm² or more, a tensile strength of 20 kg/mm² or more and an elongation percentage of 5% or more, a softening point higher than a molding temperature for the thermosetting resin forming the thermosetting resin layers on both sides thereof, and a relative dielectric constant of 2.5 or more.

5. A method as claimed in claim 4, wherein surfaces of the heat resistant film are subject to a surface nodular treatment before the heat resistant film is bonded with the copper foils with a resin.

## Patentansprüche

1. Doppelseitig kupferkaschiertes Laminat zur Bildung einer Kondensatorschicht in einer inneren Lage einer mehrschichtigen Leiterplatte, die eine Schichtstruktur aufweist, das auf beiden Seiten an äußeren Schichten leitfähige Kupferfolienschichten und eine dielektrische Harzschicht aufweist, die zwischen den Kupferfolien an der einen Seite und an der anderen Seite angeordnet ist, wobei:
die Harzschicht eine Dreischichtstruktur besitzt, die eine wärmehärtende Harzschicht, eine wärmebeständige Folienschicht und eine wärmehärtende Harzschicht in der angegebenen Reihenfolge aufweist;
die wärmehärtende Harzschicht aus einem Epoxidharz gebildet ist; und
die wärmebeständige Folienschicht aus einem Harzmaterial hergestellt ist, das ein Elastizitätsmodul von 300 kg/mm² oder darüber, eine Zugfestigkeit von 20 kg/mm² oder darüber, eine Reißdehnung von 5 % oder mehr und einen Erweichungspunkt über der Formtemperatur des wärmehärtbaren Harzes, das an ihren beiden Seiten die wärmehärtenden Harzschichten bildet, und eine relative Dielektrizitätskonstante von 2,5 oder darüber aufweist, **dadurch gekennzeichnet, dass** die Dreischichtstruktur eine Gesamtdicke von 25 µm oder weniger besitzt und die wärmebeständige Folienschicht aus Polyethylenterephthalat, Polyethylennaphthalat, Polyvinylcarbazol, Polyphenylensulfid, Polyamid, aromatischem Polyamid, Polyamidimid, Polyethernitril oder Polyetheretherketonharz gebildet ist.

2. Doppelseitig kupferkaschiertes Laminat nach Anspruch 1, wobei die wärmehärtende Harzschicht und/oder die wärmebeständige Folienschicht, die aus der Harzschicht gebildet ist, als Füllstoff ferroelektrische Mikropartikel aufweisen.

3. Doppelseitig kupferkaschiertes Laminat nach Anspruch 1 oder Anspruch 2, wobei die Dicke der wärmebeständigen Folienschicht im Bereich von 0,5 bis 12,5 µm liegt.

4. Verfahren zur Herstellung eines doppelseitig kupferkaschierten Laminats zur Bildung einer Kondensatorschicht in einer Innenlage einer mehrschichtigen Leiterplatte mit Schichtstruktur, wobei das kupferkaschierte Laminat wie in einem der Ansprüche 1 bis 3 definiert ist, worin auf beide Oberflächen einer wärmebeständigen Folienschicht mit einem Harz versehene Kupferfolien, die jede eine wärmehärtende Harzschicht in einem teilweise gehärteten Zustand aufweist, so aufgebracht werden, dass deren Harzschichten einander zugewandt sind, und zum Verbinden heißgepresst werden, wodurch das doppelseitig kupferkaschierte Laminat gebildet wird,
worin ein für die wärmebeständige Folienschicht verwendetes Material von einem Harzmaterial gebildet ist, das ein Elastizitätsmodul von 300 kg/mm² oder darüber, eine Zugfestigkeit von 20 kg/mm² oder darüber, eine Reißdehnung von 5 % oder mehr und einen Erweichungspunkt über der Formtemperatur des wärmehärtbaren Harzes, das an ihren beiden Seiten die wärmehärtenden Harzschichten bildet, und eine relative Dielektrizitätskonstante von 2,5 oder darüber aufweist.

5. Verfahren nach Anspruch 4, worin die Oberflächen der wärmebeständigen Folie einer nodularen Oberflächenbehandlung unterzogen werden, bevor die wärmebeständige Folie mit den mit einem Harz versehenen Kupferfolien verbunden wird.

## Revendications

1. Stratifié cuivré à double face destiné à former une couche de condensateur dans une couche interne d'une carte de circuit imprimé multicouche présentant une structure stratifiée qui comprend des couches de feuilles de cuivre conductrices disposées au niveau de couches extérieures sur les deux côtés de celles-ci et une couche de résine diélectrique prise en tenaille entre les feuilles de cuivre sur un côté et l'autre côté, où :
la couche de résine présente une structure à trois couches comprenant une couche de résine thermodurcissable, une couche de film résistant à la chaleur et une couche de résine thermodurcissable dans cet ordre ;
la couche de résine thermodurcissable est réalisée en un matériau de résine époxy ; et
la couche de film résistant à la chaleur est réalisée en un matériau de résine ayant un module de Young supérieur ou égal à 300 kg/mm², une résistance à la traction supérieure ou égale à 20 kg/mm² et un pourcentage d'allongement supérieur ou égal à 5%, un point de ramollissement supérieur à une température de moulage de la résine thermodurcissable formant les couches de résine thermodurcissable sur les deux côtés de celles-ci, et une permittivité relative supérieure ou égale à 2,5, **caractérisé en ce que** la structure à trois couches a une épaisseur totale inférieure ou égale à 25 µm et la couche de film résistant à la chaleur est réalisée en une résine quelconque parmi une résine de polyéthylène téréphtalate, de polyéthylène naphtalate, de polyvinylcarbazole, de sulfure de polyphénylène, de polyamide, de polyamide aromatique, de polyamide-imide, de polyéthernitrile et de polyétheréthercétone.

2. Stratifié cuivré à double face selon la revendication 1, dans lequel la couche de résine thermodurcissable et/ou la couche de film résistant à la chaleur constituant la couche de résine contiennent des microparticules ferroélectriques en tant que matière de remplissage.

3. Stratifié cuivré à double face selon la revendication 1 ou 2, dans lequel l'épaisseur de la couche de film résistant à la chaleur se trouve dans une plage allant de 0,5 à 12,5 µm.

4. Procédé de fabrication d'un stratifié cuivré à double face destiné à former une couche de condensateur dans une couche interne d'une carte de circuit imprimé multicouche présentant une structure stratifiée, ledit stratifié cuivré étant tel que défini dans l'une quelconque des revendications 1 à 3, dans lequel des feuilles de cuivre avec une résine ayant chacune une couche de résine thermodurcissable à l'état semi-durci sont superposées sur les deux surfaces d'une couche de film résistant à la chaleur avec les couches de résine de celles-ci faisant face les unes aux autres et pressées à chaud pour se coller, ce qui permet de produire le stratifié cuivré à double face,
où un matériau utilisé pour la couche de film résistant à la chaleur est un matériau de résine ayant un module de Young supérieur ou égal à 300 kg/mm², une résistance à la traction supérieure ou égale à 20 kg/mm² et un pourcentage d'allongement supérieur ou égal à 5%, un point de ramollissement supérieur à une température de moulage de la résine thermodurcissable formant les couches de résine thermodurcissable sur les deux côtés de celles-ci, et une permittivité relative supérieure ou égale à 2,5.

5. Procédé tel que revendiqué dans la revendication 4, dans lequel des surfaces du film résistant à la chaleur sont soumises à un traitement nodulaire de surface avant que le film résistant à la chaleur ne soit collé aux feuilles de cuivre avec une résine.
